# EUROPEAN PATENT APPLICATION

(11) **EP 4 734 151 A1**
(43) Date of publication of application: **29.04.2026**
(21) Application number: 24208143.8
(22) Date of filing: 22.10.2024
(51) Int. Cl.: H01L 21/66

(54) **SEMICONDUCTOR CHIP, SEMICONDUCTOR WAFER AND METHOD OF FABRICATING A SEMICONDUCTOR CHIP**

(71) Applicant: Infineon Technologies Austria AG, 9500 Villach (AT)
(72) Inventor: KE, Kian Seng, 09000 Kulim (MY); PRECHTL, Gerhard, 9232 Rosegg (AT)
(74) Representative: Infineon Patent Department

(57) **Abstract**

In an embodiment, a method of fabricating a semiconductor chip is provided. The method comprises providing a semiconductor wafer, forming active device structures in component positions with kerf regions located at least one of adjacent to and between the component positions, forming one or more auxiliary structures at least partially in one or more of the kerf regions, forming a metallization structure on the component positions and on the kerf regions, forming one or more auxiliary contact pads in the component positions that are electrically coupled to one or more of the auxiliary structures in the kerf regions and singulating the wafer by cutting along the kerf regions.

## Description

### BACKGROUND

In various semiconductor manufacturing processes, semiconductor wafers are separated into individual chips. This separation process may also be known as dicing or singulating. The separation process commonly occurs in kerf regions positioned between component positions. The kerf regions may contain various auxiliary structures such as, for example, process control monitor (PCM) structures, lithographic structures, alignment structures, metal pads, contacts etc. Separating the semiconductor wafer by cutting or sawing along the kerf regions also results in cutting or sawing through the auxiliary structures positioned in the kerf regions. This can cause undesirable effects such as sidewall chipping, dicing tool abrasive wear etc.

US 2015/006487781 discloses a method which seeks to avoid these undesirable effects in which an auxiliary structure in a kerf region is removed and, afterwards, the semiconductor wafer separated along the kerf region. However, further improvements would be desirable.

### SUMMARY

In an embodiment, a method of fabricating a semiconductor chip is provided. The method comprises providing a semiconductor wafer comprising component positions with kerf regions located at least one of adjacent to and between the component positions, forming active device structures in component positions , forming one or more auxiliary structures at least partially in one or more of the kerf regions, forming a metallization structure on the component positions and on the kerf regions, forming one or more auxiliary contact pads in the component positions that are electrically coupled to one or more of the auxiliary structures in the kerf regions and singulating the wafer by cutting along the kerf regions.

In an embodiment, a semiconductor chip is provided that comprises a semiconductor substate comprising a first major surface, an active device and a metallization structure located on the first major surface. The metallization structure comprises an electrically conductive redistribution structure for the active device, at least one auxiliary contact pad and at least one interconnect that extends from the auxiliary contact pad. The at least one auxiliary contact pad and the at least one interconnect are electrically separate from the active device.

In an embodiment, a semiconductor wafer is provided that comprises a plurality of component positions, each comprising an active device structure, kerf regions located at least one of adjacent to and between the component positions and at least one auxiliary structure at least partially positioned in one or more of the kerf regions. The auxiliary structure is electrically coupled to at least one auxiliary contact pad that is located on at least one of the plurality of component positions.

Those skilled in the art will recognize additional features and advantages upon reading the following detailed description, and upon viewing the accompanying drawings.

### BRIEF DESCRIPTION

The elements of the drawings are not necessarily to scale relative to each other. Like reference numerals designate corresponding similar parts. The features of the various illustrated embodiments can be combined unless they exclude each other. Exemplary embodiments are depicted in the drawings and are detailed in the description which follows.
Figure 1A illustrates a schematic plan view of a top side of a semiconductor wafer including at least one auxiliary structure in a kerf region.
Figure 1B illustrates a schematic cross-sectional view of the semiconductor wafer of figure 1.
Figure 1C illustrates a top view of a semiconductor chip separated from the semiconductor wafer of figures 1A and 1B.
Figure 2, which includes figures 2A and 2B, illustrates exemplary transistor devices which may be used for the auxiliary structure in the kerf region.
Figure 3, which includes figures 3A and 3B, illustrates two examples of an auxiliary structure which is located in a kerf region of a wafer.
Figure 4, which includes figures 4A to 4C, illustrates exemplary embodiments of a metallization structure for forming an auxiliary pad.
Figure 5 illustrates a top view of a corner of a semiconductor chip in which an auxiliary pad is located outboard of a sealing ring.
Figure 6 illustrates a top view of a portion of a semiconductor wafer in which a capacitor structure is located under an auxiliary pad.
Figure 7 illustrates a flowchart of a method for fabricating a semiconductor wafer with an auxiliary pad that is arranged in a component position and that is connected to an auxiliary structure in a kerf region.

### DETAILED DESCRIPTION

In the following detailed description, reference is made to the accompanying drawings, which form a part hereof, and in which is shown by way of illustration specific embodiments in which the invention may be practiced. In this regard, directional terminology, such as "top", "bottom", "front", "back", "leading", "trailing", etc., is used with reference to the orientation of the figure(s) being described. Because components of the embodiments can be positioned in a number of different orientations, the directional terminology is used for purposes of illustration and is in no way limiting. It is to be understood that other embodiments may be utilized and structural or logical changes may be made without departing from the scope of the present invention.

The following detailed description, thereof, is not to be taken in a limiting sense, and the scope of the present invention is defined by the appended claims.

A number of exemplary embodiments will be explained below. In this case, identical structural features are identified by identical or similar reference symbols in the figures. In the context of the present description, "lateral" or "lateral direction" should be understood to mean a direction or extent that runs generally parallel to the lateral extent of a semiconductor material or semiconductor carrier or semiconductor wafer. The lateral direction thus extends generally parallel to these surfaces or sides. In contrast thereto, the term "vertical" or "vertical direction" is understood to mean a direction that runs generally perpendicular to these surfaces or sides and thus to the lateral direction. The vertical direction therefore runs in the thickness direction of the semiconductor material or semiconductor carrier or semiconductor wafer.

As employed in this specification, when an element such as a layer, region or substrate is referred to as being "on" or extending "onto" another element, it can be directly on or extend directly onto the other element or intervening elements may also be present. In contrast, when an element is referred to as being "directly on" or extending "directly onto" another element, there are no intervening elements present.

As employed in this specification, when an element is referred to as being "connected" or "coupled" to another element, it can be directly connected or coupled to the other element or intervening elements may be present. In contrast, when an element is referred to as being "directly connected" or "directly coupled" to another element, there are no intervening elements present.

A depletion-mode device, such as a depletion-mode transistor, has a negative threshold voltage which means that it can conduct current at zero gate voltage. These devices are normally on. An enhancement-mode device, such as an enhancement-mode transistor, has a positive threshold voltage which means that it cannot conduct current at zero gate voltage and is normally off. An enhancement-mode device is not limited to low voltages and may also be a high-voltage device.

As used herein, the phrase "Group III-Nitride" refers to a compound semiconductor that includes nitrogen (N) and at least one Group III element, including aluminum (Al), gallium (Ga), indium (In), and boron (B), and including but not limited to any of its alloys, such as aluminum gallium nitride (AlₓGa₍₁₋ₓ₎N), indium gallium nitride (In_{y}Ga_{(1-y)}N), aluminum indium gallium nitride (AlₓIn_{y}Ga_{(1-x-y)}N), gallium arsenide phosphide nitride (GaAsₐP_{b}N_{(1-a-b)}), and aluminum indium gallium arsenide phosphide nitride (AlₓIn_{y}Ga_{(1-x-y)}AsₐPbN_{(1-a-b)}), for example. Aluminum gallium nitride and AlGaN refers to an alloy described by the formula AlₓGa₍₁₋ₓ₎N, where 0 < x < 1.

A semiconductor wafer may comprise component positions with kerf regions located at least one of adjacent to and between the component positions. The kerf regions may contain various auxiliary structures such as, for example, process control monitor (PCM) structures, lithographic structures, alignment structures, metal pads, contacts etc.

To avoid undesirable effect sch as sidewall chipping and dicing tool abrasive wear it is advisable to avoid placing auxiliary structures, such as PCM structures, in the kerf region (scribeline or saw street), these auxiliary structures may be placed at a Block PCM (BPCM). A Block PCM may occupy one or more of the chip positions of the wafer. This approach, however, sacrifices the chip area for productive chips and reduces the yield of chips per wafer.

In the present disclosure, the auxiliary pads, e.g. PCM pads, are not placed in the kerf region but are located on the component position, for example, at the chip corner and act as a landing pad and enable the probing of PCM structures at cross street, i.e. the intersection between perpendicular extending kerf regions. The metal load is much smaller without the metal pad at saw street, thus testing at scribeline is possible and a block PCM arrangement can be avoided to realize cost advantages.

The PCM pad is located inside the product, e.g. at one of the four corners of the chip, in, for example, the region of seal ring. The PCM structures are located in the kerf region, e.g. at the cross street region, with an interconnect/routing from the pad via the kerf region to the PCM structure. With this design, yield improvement is achieved.

The PCM structure may be located at the cross street in the kerf region and/or underneath the PCM pad. Electrical routing is made from the pad to the active PCM structure with various options of an interconnect layer formed in the front side metallization. This enables a Block PCM to be avoided which occupies area for the productive chip, and substantial yield gain can be realized.

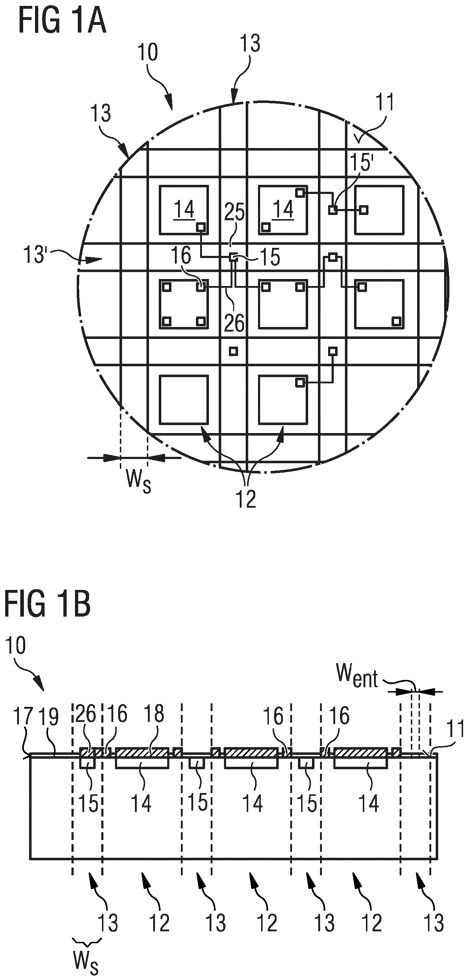

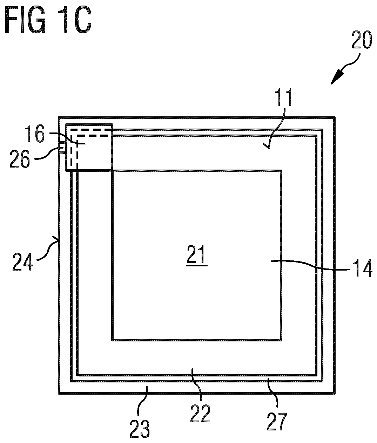

Figure 1 includes figures 1A to 1C, whereby figure 1A illustrates a schematic plan view of a top side of a semiconductor wafer 10, figure 1B illustrates a schematic cross-sectional view of the semiconductor wafer 10 of figure 1A and figure 1C illustrates a top view of a semiconductor chip that has been separated from the semiconductor wafer 10 of figures 1A and 1B.

Figure 1A illustrates a schematic view of a top side 11 of the semiconductor wafer 10. The semiconductor wafer 10 is illustrated as a circular wafer. However, the wafer 10 may also include a notch or a flat edge for alignment purposes. The semiconductor wafer 10 may comprise a single crystal silicon wafer which may comprise an epitaxially deposited silicon layer, commonly known as an epi layer, or a III-V semiconductor wafer or a wafer including a base wafer and an epitaxially grown Group III nitride multilayer structure on the base wafer.

The semiconductor wafer 10 includes a plurality of component positions 12 with kerf regions 13 located at least one of adjacent and between the component positions 12. The component positions 12 are typically arranged in rows and columns and are separated from their nearest neighbour by kerf regions 13. The kerf regions 13 may also be called a separation region or a saw street. A kerf region 13 is positioned adjacent the outermost component positions 12 so that each component position 12 is bounded on all lateral sides by a kerf region 13. The kerf regions 13 typically form a regular grid structure of vertical and horizontal (longitudinal and transverse) kerf regions 13, 13' that intersect at intersections 25. One component position 12 is bordered by two adjacent vertical kerf regions 13 and two adjacent horizontal kerf regions 13' and comprises four corners.

To separate or singulate the semiconductor wafer 10 into individual chips, the wafer 10 is cut along the kerf regions 13 so that one component position 12 provides one chip. A laser or a mechanical saw may, for example, be used to singulate the wafer 10. The kerf regions 13 have a width wₛ which is typically slightly larger than the width of the material that is removed by the separation process, e.g. w_{cut}. The width wₛ of the kerf regions 13 may lie in the region of 40 µm to 120 µm or 60 µm to 90 µm.

The component positions 12 include an active device structure 14. Typically, each component position 12 of the semiconductor wafer includes an active device structure 14 and may include the same active device structure. However, in some embodiments, the active device structure in one or more of the component positions 12 may differ from that active device structure of one or more further component positions 12. At least one auxiliary structure 15 is positioned in one or more of the kerf regions 13. The auxiliary structure 15 is electrically coupled to an auxiliary contact pad 16 that is located on one of the component positions 12. An interconnect 26, e.g. a metal trace, extends from the auxiliary contact pad 16 to the auxiliary structure 15. The auxiliary structure 15 may comprise one or more of the group consisting of process control monitor (PCM) structures, e.g. a resistor and/or a capacitor ad/or a transistor structure, lithographic structures, alignment structures, metal pads, contacts etc.

The auxiliary contact 16 may be located at the corner of the first major surface of the component position 12. One auxiliary contact pad 16 may be arranged on two or more of the component positions 12 bordering an intersection15, for example at the corner of two or more of the component positions 12 bordering the intersection15. In an another first and second auxiliary contact pads 16 are located on a different one of the component positions 12 and at least one interconnect 26 electrically connects the first and second auxiliary contact pads 16 to at least one auxiliary structure 15.

The auxiliary structure 15 in the kerf region 13 is a structure formed during the processing of a semiconductor wafer which does not interact with or affect the active device structures 14 in the component positions 12 of the processed semiconductor wafer 10. The auxiliary structure 15 may be used to evaluate the manufacturing process of a semiconductor device such as the active device structures 14 in the component positions 12. Examples of auxiliary structures 15 include, for example, process control monitor (PCM) devices, for example electric PCM devices, lithographic structures, metal pads, contacts for electrochemical etching, and alignment structures. The wafer 10 may also include auxiliary structures of different types for different purposes.

In some embodiments, at least one of the auxiliary structures 15 has the same structure as the active device structure 14.

In some embodiments, the auxiliary structure 15 and the active device structure 14 each comprise a transistor device structure. The auxiliary structure 15 may be connected to three auxiliary pads located on three different component positions. The auxiliary structure 15 and the active device structure 14 each comprise the same transistor device structure. The transistor device structure 14 may include a cell region that is laterally surrounded by an edge termination region. The transistor device structure 14 may be a field effect transistor device structure, for example a MOSFET device structure, such as a superjunction MOSFET using a charge compensation principle, or a HEMT. In an embodiment, the auxiliary structure 15 may be connected to four auxiliary pads 16 located on four different component positions 12, e.g. the four component positions 12 that border an intersection 25 between a longitudinal kerf region 13 and a transverse kerf region 13.

The transistor device of the auxiliary structure 15 may have a lateral size that is smaller than the lateral size of the active device structure 14 whilst having the same transistor device structure. For example, the cell region of the auxiliary structure 15 may comprise fewer cells than the cell region of the active device structure 14.

In some embodiments, at least one of the auxiliary structures 15 may include a structure for measuring one or more parameters of one or more features of the transistor device structure without the auxiliary structure 15 itself having a transistor device structure or a transistor device structure replicating the active transistor device structure 14. For example, an auxiliary structure 15 may be without trenches and be used for measuring the sheet resistance of the source and body region of the active transistor device structure in the component positions or the auxiliary structure 15 may include a trench filled with polysilicon and be used for measuring the resistance of the polysilicon in the trench.

In some embodiments, at least a part of one of the auxiliary structures 15 may be located under the auxiliary pad 16. For example, a capacitor structure comprising a dielectric sandwiched between a lower conductive plate and an upper conductive plat may be located under the auxiliary pad 16.

The kerf region 13 may include further at least one interconnect 26 in the form of a metal interconnect or metal trace that extends between and is coupled between the auxiliary structure 15 located in the kerf region 13 and the auxiliary pad 16 that is located on the component position 12. The interconnect 26 is also partly located on the component position 12, since it extends to and is connected with the auxiliary contact pad 16.

The location of the auxiliary contact pad 16 on the component position rather than in the kerf region 13 means that the auxiliary pad 16 is not singulated during separation of the semiconductor chips from the semiconductor wafer 10 by the cutting action along the kerf regions 13. The auxiliary structure 15, which includes less metal that the auxiliary pad 16, may, however, be cut through during singulation of the wafer 10 along the kerf regions 13. During separation of the semiconductor chips from the semiconductor wafer 10 by cutting the wafer along the kerf regions 13 and through the auxiliary structure 15, the location of the auxiliary contact pad 16 on the component position rather than in the kerf region 13 may assist in reducing defects or defective chips, such as reducing undesirable chipping of the top side, side walls and/or rear surface of the semiconductor material

The location of the auxiliary contact pad 16 on the component position 12 rather than in the kerf region 13 may also assist in increasing the yield. Since the semiconductor wafer 10 is cut through the auxiliary structures 15, an increase in the width wₛ of the kerf region 13 to enable a cut to be formed laterally adjacent the auxiliary structure 15 is avoided. Furthermore, additional processing to remove auxiliary structures 15 and or auxiliary pads 16 from the kerf region 13 before separating the semiconductor wafer 10 into chips can be avoided.

As illustrated in figure 1A, one or more auxiliary pads 16 may be located on one component position 12. For example, one component position 12 may include four auxiliary pads 16, one located in each corner. Two or more auxiliary contact pads 16 that are located on different component positions may be coupled to a single auxiliary structure 15, e.g. to opposing ends of a resistor which may be formed by a conductive trace or interconnect form on the first major surface 11 or to the two plates of a capacitor. One or more auxiliary structures 15 may be located in the intersection 25 formed between a transverse kerf region 13 and a longitudinal kerf region 13' and be located adjacent the corners of four neighbouring component positions 12. An auxiliary structure 15' may also be arranged in the kerf region 13 between the straight edges of two neighbouring component positions 12.

The auxiliary contact pad 16 may be formed from a layer of a metallization structure and may comprise tungsten metal. In some embodiments, the auxiliary contact pad 16 has a multilayer structure, whereby tungsten, which in some embodiments is pure tungsten metal, forms the outermost sublayer of the multilayer structure of the auxiliary contact pad 16. Underlying sublayers of the multilayer structure may include a Ti/TiN structure for improving adhesion.

In some embodiments, the auxiliary contact pad 16 has an area of at least 30 µm by 30 µm or at least 50 µm by 50 µm or at least 80 µm by 80 µm. This area is suitable for accepting a probe.

The active device structure 14 may also include a metallisation structure 17 arranged on the top surface 11 of the semiconductor wafer 10 in at least the component positions 12, as can be seen in the cross-sectional view of Figure 1B. The metallization structure 17 may comprise one or more conducive layers 18 and one or more electrically insulating layers 19.

The metallisation structure 17 arranged in the component positions 12 is positioned on, and electrically coupled with, the active device structure 14, in that component position 12. The auxiliary pad 16 and the interconnect 26 between the auxiliary pad 16 and the auxiliary structure 15 may be formed from one or more of the electrically conductive layers 18 of the metallization structure 17. The auxiliary pad 16 is electrically insulated from the active device structure 14 located in the component position 12. The auxiliary contact pad 16 and the interconnect 26 are electrically separate from the active device structure 14.

In some embodiments, the metallization structure 17 comprises a first electrically conductive layer 18 that is positioned on, and electrically coupled with, the active device structure 14 in the component position 12 and the auxiliary contact pad 16 is substantially coplanar with the first electrically conductive layer 18. The auxiliary contact pad 16 is electrically insulated from the active device structure 14.

In some embodiments, the metallization structure 17 comprises a redistribution structure for the active device structures 14 in the component positions 12 and at least one interconnect 26 that extends from the auxiliary contact pad 16 to the auxiliary structure 15 in the kerf region 13. The auxiliary contact pad 16 and the interconnect 26 are electrically separate from the active device structure 14.

In some embodiments, the metallization structure 17 includes at least one electrically conductive layer, for example two or more electrically conductive layers 18, whereby the electrically conductive layers may be separated by an electrically insulating layer 18. For example, an electrically insulating layer may be arranged between the first conductive layer 18 and the second conductive layer 19 and at least portions of the two conductive layers 18, 18' may be electrically connected by vias extending through the intervening insulation layers. The first conductive layer 18 and the second conductive layer 18' may be structured to provide a redistribution structure. The redistribution structure may provide two or more conductive redistribution paths that are electrically insulated from one another. For example, for a transistor device structure, a redistribution structure may be provided in the component position 12 for each of the source, drain and gate of the transistor device.

Figure 1C illustrates a plan view of a semiconductor chip 20 which has been singulated from the wafer 10 by dicing or sawing along kerf regions 13. The semiconductor chip 20 is formed from a component position 12 and includes an active device structure 14.

The semiconductor chip 20 comprises an edge region 23 that laterally surrounds the active device structure 14 and extends to the side faces 24 of the semiconductor chip 20. The auxiliary contact pad 16 is located in the edge region 23.

In some embodiments, the edge region 23 comprises one or more continuous rings 27 and the auxiliary contact pad 16 is located on the one or more continuous rings 27. Alternatively, the auxiliary contact pad 16 is arranged laterally between a side face 24 of the chip 20 and the continuous ring 27 or outermost continuous ring 27.

The active device structure 14 may be a trench-based MOSFET and includes a cell field 21 that is laterally surrounded by an edge termination region 22. The edge termination region 22 is in turn laterally surrounded by the peripheral edge region 23. The peripheral edge region 23 comprises a remaining portion of the kerf region 13. The semiconductor chip 20 includes the auxiliary pad 16 in the peripheral edge region 23, for example in a corner of the first major surface 12 and may also include a portion of the interconnect 26 that extends from the auxiliary contact pad 16. The auxiliary contact pad 16 and any portion of the interconnect 26 are electrically separate from and not connected to the active device structure 14.

To separate the semiconductor wafer 10 into individual semiconductor chips, a portion of the kerf region 13 is removed, for example by mechanical sawing or laser cutting through the thickness of the semiconductor wafer. The saw or cut that is inserted into the kerf region 13 has a width, w_{cut}, which is less than the width wₛ of the kerf regions 13. At least part of the auxiliary structure 15 and the interconnect 26 are removed by this cut through the kerf region 13. Consequently, the most peripheral regions of the semiconductor chips 20 are formed by a portion of the kerf region 13 that is not removed by the separating action and that is positioned immediately adjacent the edge region 23 of the active device structure 14. The auxiliary pad 16 and in some embodiments also portions of the interconnect 26 are positioned in the peripheral edge region 23 of the separated semiconductor chip 20.

The metallization structure 17 may be formed on the wafer 10 by forming a first conductive layer, e.g. from a metal such as tungsten, on the first major surface, and structuring the first conductive layer to form a redistribution structure for the active device. The first conductive layer may be structured to form at least one auxiliary contact pad that is electrically separate from the active device structure and/or an interconnect that extends from at least one of the auxiliary contact pads to at least one of the auxiliary structures.

In some embodiments, a second conductive layer of the metallization structure may be formed on the first electrically conductive layer and structured to form a redistribution structure for the active device. In some embodiments, the second electrically conductive layer is structured to form at least one auxiliary contact pad that is electrically separate from the active device structures and/or an interconnect that extends from at least one of the auxiliary contact pads to at least one of the auxiliary structures.

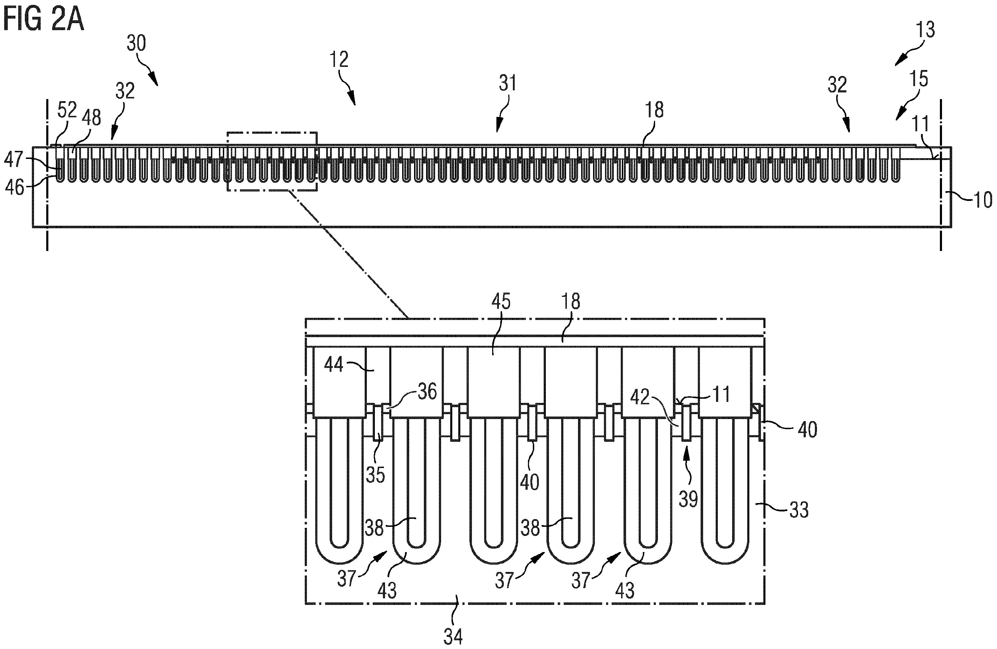

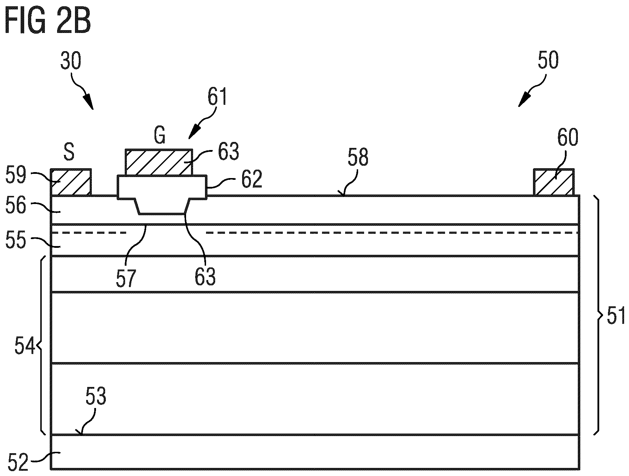

As discussed above, in some embodiments, the auxiliary structure 15 and the active device structure 14 each comprise a transistor device structure. Figure 2, which includes figures 2A and 2B, illustrate examples of a transistor device structure 30, which may be used for the auxiliary structure 15 and the active device structure 14. However, other types of transistor structure may also be used.

Figure 2A illustrates a cross-sectional view of an exemplary transistor device structure 30 which may form the active device structure 14 and/or the auxiliary structure 15. In this embodiment, the transistor device is a silicon-based transistor device, e.g. a MOSFET. The transistor device structure 30 includes a cell region or cell field 31 that is laterally surrounded by an edge termination region 32. The insert of Figure 2A illustrates an enlarged view of a portion of the cell region 31. The transistor device structure 30 may be a field effect transistor device structure.

The transistor device structure 30 is, in the illustrated embodiment of figure 2A, an auxiliary structure 15 which is positioned in a kerf 13 of the semiconductor wafer 10. However, the active device structure 14 in the component position 12 may also comprise this transistor device structure 30 so that figure 2A may equally refer to the active device structure 14 in the component position 12 illustrated in figure 1.

The transistor structure 30 forming the auxiliary structure 15 is commonly a laterally smaller version of the transistor structure of the active device structure 14 in the component position 12 and includes not only the cell region 31, but also the edge termination region 32. The number of cells in the cell region 31 of the auxiliary structure 15 is, however, less than the number of cells in the cell region 31 of the active device structure 14. The smaller lateral size of the transistor structure 30 of the auxiliary structure 15 may be useful for process monitoring purposes since the smaller lateral area results in a higher on-resistance which can be more easily and accurately measured. Further properties of the transistor structure 30 which may be measured on the auxiliary structure 15 include breakdown voltage.

In some embodiments, the cell region 31 comprises a semiconductor layer 33, which may be formed by the material of the semiconductor wafer 10, for example silicon, or an epitaxial layer of silicon formed on a single crystal silicon wafer. The semiconductor layer 33 comprises a first conductivity type and forms the drift region 34. The cell region 31 further includes a body region 35 comprising a second conductivity type, that opposes the first conductivity type, the body region 35 being arranged on the drift region 34, and a source region 36 comprising the first conductivity type arranged on the body region 35. The first conductivity type may be n-type and the second conductivity type p-type, or vice versa. The transistor structure 30 further includes a plurality of trenches 37 extending into the semiconductor layer 33 from the first surface 11.

In some embodiments, such as that illustrated in Figure 2A, the transistor device structure 30 comprises a first plurality of trenches 37 that have a columnar form and each comprise a field plate 38. In this embodiment, the cell region 31 further comprises a second plurality of trenches 39 that are elongate or strip-like, each elongate trench 39 comprising a gate electrode 40. The elongate trenches 39 may extend substantially parallel to one another into the plane of the drawing. The elongate trenches 39 are alternately arranged with a row of discrete columnar trenches 37, whereby the rows extend into the plane of the drawing and substantially parallel to the elongate trenches 39.

In a further embodiment of a transistor structure, the gate electrode 40 is located above, and is electrically insulated from the field plate 38 in the trench 37. In this embodiment, the trenches 37 may be elongate or strip-like in top view.

Referring to figure 2A, the body region 35 and source regions 36 extend between the columnar trenches 37. The elongate trenches 39 including the gate electrode 40 extend into the semiconductor wafer 33 from the top surface 41 through the source region 36 and body region 35. The elongate trenches 39 are lined with an insulation layer 42, forming a gate insulation or gate oxide. The base of the elongate trenches 39 may extend into the top of the drift region 34. The columnar trenches 37 extend to a greater depth from the first surface 11 of the semiconductor wafer 10 into the body of the semiconductor layer 33. The columnar trenches 37 also lined with an insulating layer 43 which insulates the field plate 38 from the drift region 34.

The transistor device structure 30 further comprises one or more insulation layers 44 which are arranged on the first surface 41 of the semiconductor wafer 10 and on the elongate trenches 39 including the gate electrodes 40 and on the source regions 36. The insulation layer 44 or uppermost insulation layer, if two or more insulation layers are provided may be BPSG (borophosphosilicate glass). The first conductive layer 18 and the auxiliary contact pad 16 and the interconnect o26 to the auxiliary structure 15 may be arranged on the insulation layer 44.

The transistor device structure 30 further comprises vertical contacts 45, which may comprise a metal, such as tungsten, and have the form of a tungsten plug. Each metal contact 45 extends through the one or more insulation layers 44 and is arranged on a field plate 38 in one of the columnar trenches 37. The first conductive layer 18 or auxiliary contact pad 16 is arranged on the insulating layers 44 and on the metal contact 45 and is electrically coupled to the field plates 38, source region 36 and the body region 35.

The edge termination region 32 also includes columnar trenches 46 comprising a field plate 47. The field plates 47 are electrically coupled to the first conductive layer 18 by tungsten plugs 48 as in the cell region 31. The edge termination region 32 is, however, free of source region and elongate trenches comprising the gate electrode so that the semiconductor layer 33 extends to the upper surface 41 and is in direct contact with the insulating layer or layers 44. The body region may be positioned in some portions of the edge termination region 32.

The transistor device structure 30 is, however, not limited to this particular structure any may have other structures. For example, in some embodiments, each of the trenches comprising a field plate is elongate. In some embodiments, each of the trenches is elongate and comprises a field plate and a gate electrode arranged on and electrically isolated from the field plate. In some embodiments, each of the trenches is elongate and the plurality of trenches form a series of stripes bordering strip -like mesas in which the drift region, body region and source region are arranged. The transistor device 30 may be MOSFET or a IGBT or a BJT device.

One or both of the auxiliary structure and forming the active device structure may be formed by forming a body region, e.g. by implantation, comprising a second conductivity type that opposes the first conductivity type in a semiconductor layer comprising a first conductivity type forming a drift region, forming a source region, e.g. by implantation, comprising the first conductivity type on the body region, forming an elongate trench in the first major surface, and forming a gate electrode and optimally a field plate, in the elongate trench. The field plate may be formed in a lower portion of the elongate trench and the gate electrode formed above the field plate in the elongate trench.

The wafer 10 and, therefore, also the active device 14 and auxiliary structure 15 are not limited to comprising silicon. For example, the wafer 10 may comprise a III-V semiconductor, such as a Group !!! nitride and the active device 14 may be a Group III nitride-based device, such as a Group III nitride-based transistor device, e.g. a HEMT (High Electron Mobility Transistor).

Figure 2B illustrates a cross-sectional view of another exemplary transistor device structure 30 which may form the active device structure 14 and/or the auxiliary structure 15. In the embodiment, the transistor device structure comprises a Group III nitride-based transistor device 50.

The Group III nitride-based semiconductor device 50 comprises a Group III nitride body 51 which is arranged on a base substrate 52, e.g. base wafer 52. The Group IIII nitride body 51 has a multilayer structure and is arranged on an upper growth surface 53 of the base substrate 52. The upper growth surface 53 is capable of supporting the epitaxial growth of one or more Group III nitride-base layers. The layers of the Group III nitride body 21 are epitaxial layers. The Group IIII nitride body 51 comprises a buffer structure 54 on the base substrate 52, a GaN channel layer 55 on the buffer structure 54 and an AlGaN barrier layer 56 on the GaN channel layer 55 which forms a heterojunction 57 therebetween which supports a two-dimensional charge gas, such as a two-dimensional electron gas (2DEG), which is indicated in the drawings by a dashed line. In this embodiment, the AlGaN barrier layer 56 forms the upper surface 58 of the Group IIII nitride body 51.

In some embodiments, the base substrate 52 is a foreign substrate, i.e. is formed of a material other than Group III nitride materials, that includes the upper or growth surface 53 which is capable of supporting the epitaxial growth of one or more Group III nitride-based layers. The base substrate 52 may be formed of silicon and may be formed of monocrystalline silicon or an epitaxial silicon layer, for example, or may be formed of sapphire, ceramic substrate, or SiC.

In some non-illustrated embodiments, the Group III nitride-based semiconductor body 51 may further include a back barrier layer. The channel layer 55 is formed on the back barrier layer and forms a second heterojunction with the back barrier layer and the barrier layer 56 is formed on channel layer 55. The back barrier layer has a different bandgap to the channel layer 55 and may comprise AlGaN, for example. The composition of the AlGaN of the back barrier layer may differ from the composition of the AlGaN used for the barrier layer 56.

A typical buffer structure 54 for a silicon base substrate 52 includes a AIN starting layer, which may have a thickness of several 100nm, on the silicon substrate followed by a AlₓGa₍₁₋ₓ₎N layer sequence, the thickness again being several 1 00nm's for each layer, whereby the Al content of about 50-75% is decreased down to 10-25% before the GaN layer or AlGaN back barrier, if present, is grown. Alternatively, a superlattice buffer can be used. Again, an AlN starting layer on the silicon substrate is used. Depending on the chosen superlattice, a sequence of AIN and AlₓGa₍₁₋ₓ₎N pairs is grown, where the thickness of the AlN layer and AlₓGa₍₁₋ₓ₎N is in the range of 2-25nm. Depending on the desired breakdown voltage the superlattice may include between 20 and 100 pairs. Alternatively, an AlₓGa₍₁₋ₓ₎N layer sequence as described above can be used in combination with the above mentioned superlattice.

The Group III-nitride based transistor device 50 includes a source contact 59, a drain contact 60 and a gate 61 arranged on the upper surface 58 of the Group III nitride body 51. The gate 61 is arranged laterally between the source contact 59 and the drain contact 60.

The gate 61 may include a p-doped region 62 arranged on the upper surface 58 and a metallic gate layer 63 arranged on the p-doped region 62. The p-doped region 62 may be a p-doped Group III nitride such as p-doped GaN or p-doped AlGaN. In some embodiments, the p-doped region 62 is arranged at least partially in a recess 63 formed in the upper surface 58 of the barrier layer 56 such that the barrier layer 56 has a smaller thickness directly under the gate 61 compared to the regions laterally adjacent the gate 61. The p-doped region 62 and recess 63 may be used to form an enhancement mode device which is normally off.

In other embodiments, the recess is omitted and the p-doped region 62 is arranged on the planar surface of the barrier layer 56 so that the barrier layer 56 has substantially the same thickness between the source and drain contacts 59, 60.

In other embodiments, the Group III nitride-based transistor device may be a depletion mode device.

The Group III nitride-based transistor device may comprise a drain finger, a source finger and a gate finger on the first major surface of the semiconductor wafer, the gate finger being arranged laterally between the source finger and the drain finger.

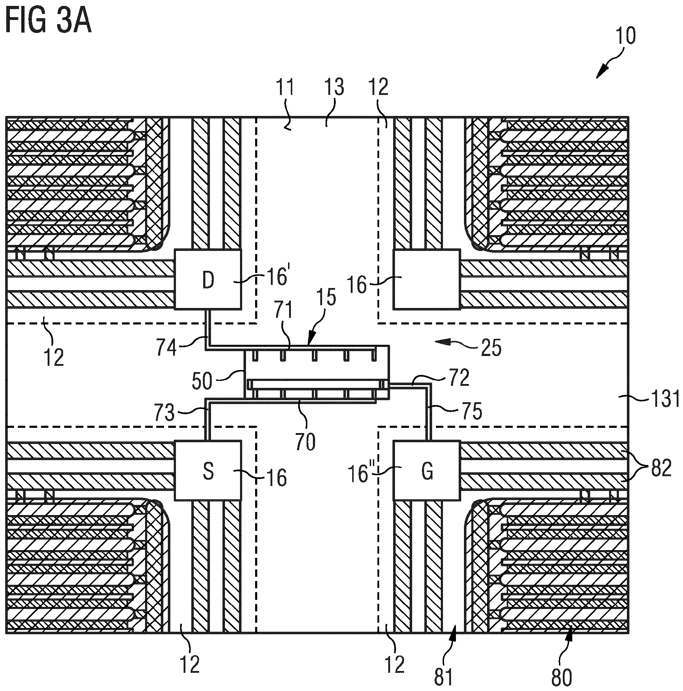

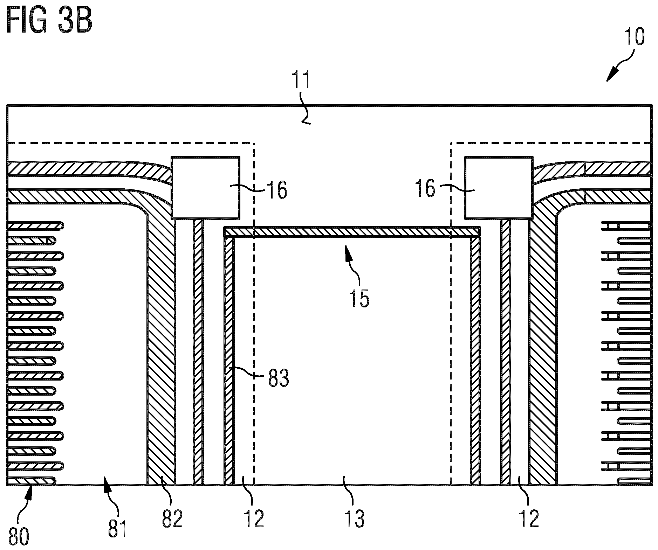

Figure 3, which includes figures 3A and 3B, illustrates two further examples of an auxiliary structure 15 which is located in the kerf region 13 of the wafer 10.

Figure 3A illustrates a portion of a topside 11 of the semiconductor wafer 10 and illustrates the transverse kerf region 13' and longitudinal kerf region 13 located between four component positions 12 which intersect at an intersection 25. In this embodiment, the auxiliary structure 15 is located at the intersection 25. Each of the component positions 12 comprises an auxiliary pad 16 arranged in its corner region so that four auxiliary pads 16 are arranged in a square and border the intersection 25 and the auxiliary structure 15.

In this embodiment, the auxiliary structure 15 comprises a transistor device 50. The transistor device 50 comprises a source contact 70, a drain contact 71 and a gate contact 72 on the upper surface of the wafer 10 in the kerf regions 13. The source contact 70 is electrically connected by an interconnect 73, e.g. a metal trace, to a first auxiliary pad 16 arranged on a first one of the neighbouring component positions 12. The drain contact 71 is electrically connected by an interconnect 74 to an auxiliary pad 16' arranged on another one of the component positions 12', e.g. the component position located in the longitudinal direction, and the gate 72 is electrically connected by an interconnect 75 to an auxiliary pad 16" arranged on a third one of the component positions 12", which is arranged in the transverse direction with the auxiliary pad 16 and component position 12.

In this embodiment, each of the component positions 12 has an active area 80 surrounded by an edge region 81 and may include an edge termination structure. The edge region 81 may comprise one or more continuous trenches that laterally surround the active area 80 in the respective component position 12, 12', ,12". In this embodiment, two continuous ring-shaped trenches 82. These continuous ring-shaped trenches 82 may be filled with electrically insulating material or conductive material. The continuous ring-shaped trenches 82 may be sealing rings which hinder the diffusion of ions into the active area 80. In this embodiment, the auxiliary pads 16, 16', 16"are arranged above these continuous ring-shaped trenches 82. The auxiliary pads 16, 16', 16" are electrically insulated from the continuous ring-shape trenches 82 and from the active area 80 and the active device in the active area 80, for example, by one or more intervening electrically insulating layers arranged on the first major surface 11.

In another embodiment, the edge region 81 may include one or more continuous ring-shapes 82 without trenches, e.g. ring-shaped metal traces, that laterally surround the active area 80 in the respective component position 12, 12', ,12".

The auxiliary pads 16, 16', 16" may be formed in the metallisation structure 70 which is positioned on the first major surface of the wafer 10 and chip. The metallisation structure 70 includes one or more electrically insulating layers and one or more electrically conductive layers.

Figure 3B illustrates an embodiment in which the auxiliary structure 15 is located in the kerf region 13 between the side faces of two neighbouring component positions 12. In this embodiment, the auxiliary structure 15 comprises a structure for measuring resistance. This structure comprises an electrically conductive metal interconnect 83 or trace which extends between a first auxiliary pad 16 arranged in the corner of one component position 12 and a second auxiliary pad 16' arranged in the corner of a neighbouring component position 12. The interconnect or trace 83 may have a meandering structure so as to increase its length and its resistance and simply the measurement of the resistance of the structure.

In this embodiment, the edge region 81 of the component positions 12, 12' comprises a single continuous ring-shaped trench 82. However, two or more continuous ring-shaped trenches 82 may be used. The auxiliary contact pad 16, 16' is arranged above the continuous ring-shaped trench 82 in the corner of the first major surface of the neighbouring component portions 12,12'.

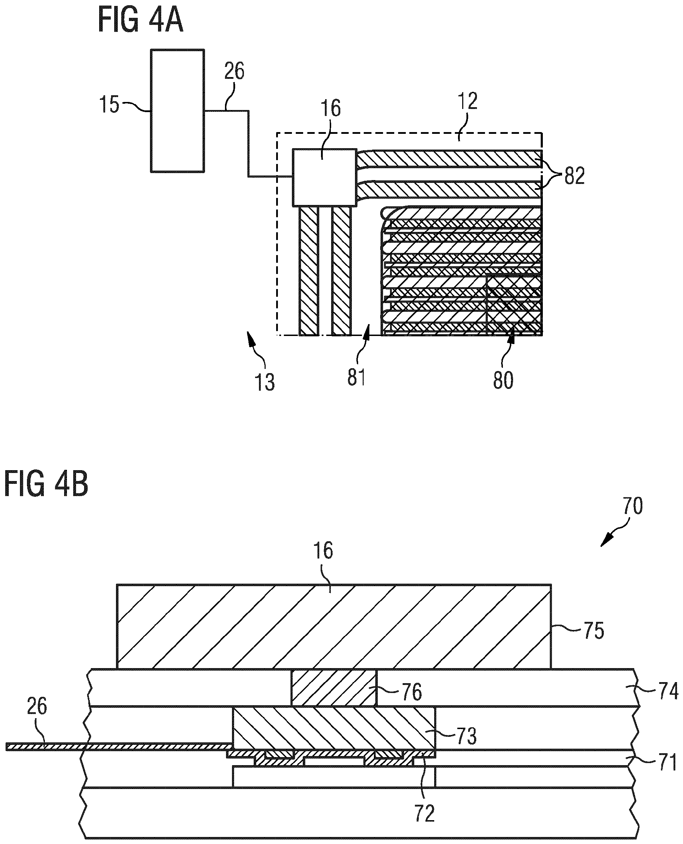

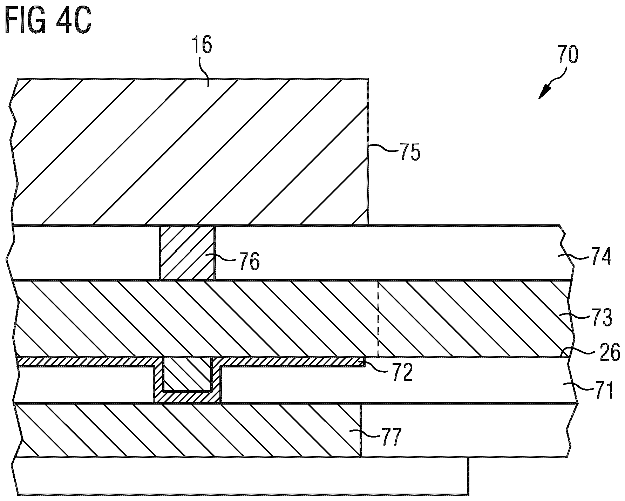

Figure 4, which includes figures 4A and 4C, illustrates exemplary embodiments of a metallization structure 70 for forming the auxiliary pad 16.

Figure 4A illustrates a top view of a portion of a component position 12 of the wafer 10 and illustrates one corner region which includes an auxiliary pad 16 at the corner which is electrically connected by an interconnect 26 to an auxiliary structure 15 located in the kerf region 13. Figure 4B illustrates a cross-section of the auxiliary pad 16. The auxiliary pads 16, 16', 16" are positioned in the corner of the first major surface 12 of each of the component positions 12, 12', 12" above the sealing ring or rings 82 which laterally surround the active device area 81 and the active device 14 in that component position 12, 12', 12".

In the embodiment illustrated in figures 4A and 4B, the metallisation structure 70 comprises a first electrically insulating layer 71, which is located on the first major surface 12, two electrically conductive layers 72, 73 which are arranged on the first electrically insulating layer 71, a second electrically insulating layer 74 which is arranged on the second electrically conductive layer 73 and a third electrically conductive layer 75 which is arranged on the second electrically insulating layer 74.

In this embodiment, the first electrically conductive layer 72 is formed of a material which be described as a diffusion barrier. This first electrically conductive layer 72 is structured so as to form the lowermost layer of the auxiliary pad 16 and also extends from under the auxiliary pad 16 into the kerf region 13 to the auxiliary structure 15 such that the auxiliary structure 15 is electrically connected to the auxiliary pad 16 by way of this first electrically conductive layer 72. The interconnect 26 from the auxiliary pad 16 to the auxiliary structure 15 is provided by a portion of the first electrically conductive layer 72.

The second electrically conductive layer 73 may be thicker than the first electrically conductive layer 72 and may be positioned under the auxiliary pad 16. The second electrically conductive layer 73 does not extend into the kerf region 13 in this embodiment. The third electrically conductive layer 75 is structured to provide the auxiliary pad 16 in the corner of the component position 12 and is electrically connected to the second electrically conductive layer by a conductive via 76 which extends through the second electrically insulating layer 74. These electrically conductive layers 72, 73, 75 of the metallisation structure 70 may also be structured to provide the redistribution structure for the active device 14 located in the component position 12. For example, if the active device 14 is a transistor device, these electrically conductive layers 72, 73, 75 can be structured to provide redistribution structure from the source contacts of the transistor cells to a common source pad, the drain contacts of the transistor cells to a common drain pad and the gates of the transistor cells to a common gate pad located on the first major surface 12.

Figure 4B illustrates an alternative arrangement for the metallisation structure 70 which includes four electrically conductive layers. An additional electrically conductive layer 77 is located between the first major surface 12 of the wafer 10 and the barrier layer provided by the first electrically conductive layer 72. The barrier layer 72 may form the interconnect 26 extending from the component position 12 into the kerf region 13 to the auxiliary structure 15. The barrier layer 72 is, however, the second electrically conductive layer in the stack beginning at the first major surface 12

One of the other electrically conductive layers, in the illustrated embodiment, the second electrically conductive layer 73, rather than the diffusion barrier layer 72, provides the interconnect 26 and extends from the auxiliary pad 16 into the kerf region 13 to the auxiliary structure 15.

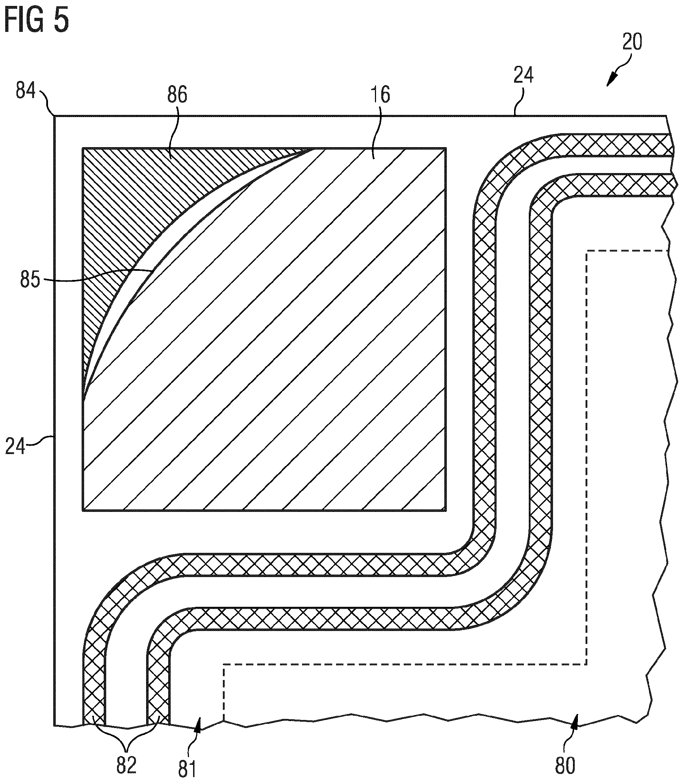

Figure 5 illustrates a top view of a corner of a semiconductor chip 80 according to an embodiment in which the auxiliary pad 16 is located outboard of the sealing ring 82 and laterally between the sealing ring 82 and the side face 84 of the chip 80. The auxiliary pad 16 is located in the corner of the first major surface 12 of the semiconductor chip 80. In this embodiment, the sealing ring 82 extends laterally around the inner two side edges of the auxiliary pad 16, which face towards the centre of the first major surface 12 of the chip 80. The continuous ring-shaped trench 82 can be considered to include a step in its shape in top view.

In some embodiments, as shown in figure 5 for example, the auxiliary pad 16 is not rectangular or square but has a rounded corner 85 which faces towards the perpendicular corner 84 of the chip 80. The area between the corner 84 of the chip 80 and the rounded corner 85 of the auxiliary pad 16 may comprise a layer 86 of polyimide.

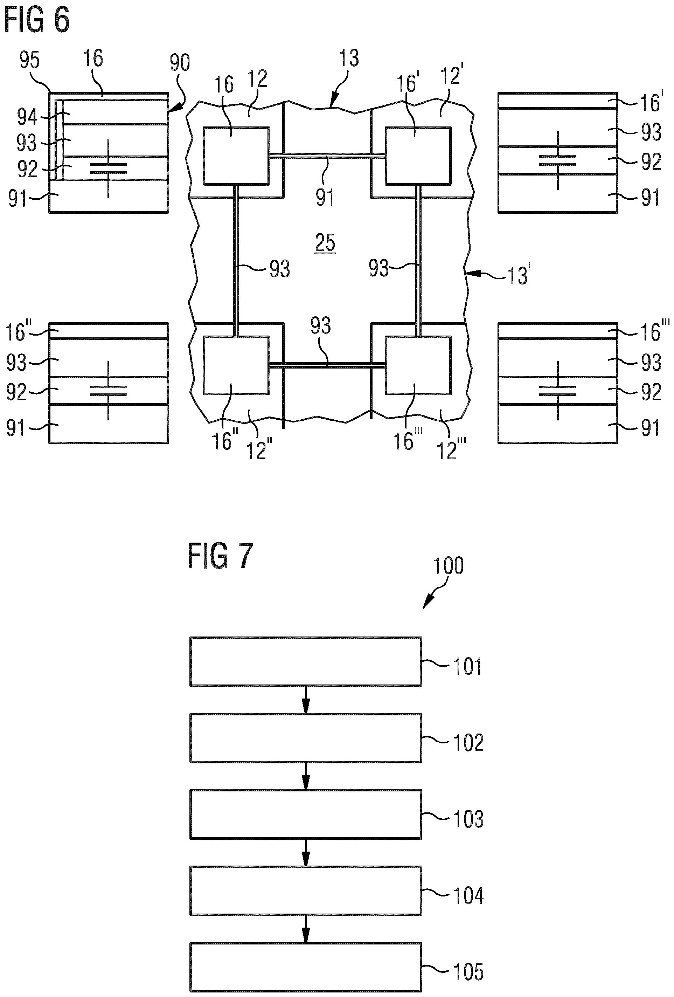

Figure 6 illustrates a top view of a portion of a wafer 10 and shows an intersection 25 which is formed between four component positions 12, 12', 12", 12‴. Each of the component positions 12, 12', 12", 12‴ comprises an auxiliary pad 16, 16', 16", 16" in the corner of the first major surface 11 of the respective component positio12, 12', 12", 12‴. The component position 12' is arranged in a horizontal row with the component position 12, the component position 12" is located in a vertical row with the component position 12 and the component position 12‴ is located in a vertical row with the component position 12', component position 12, 12', 12", 12‴ that borders the intersection 25.

In this embodiment, a capacitor structure 90 is located under each of the auxiliary pads 16, 16', 16", 16". A cross-section of each of the auxiliary pads is indicated adjacent the respective auxiliary pad 16, 16', 16", 16".

Under auxiliary pad 16, a capacitor structure 90 is formed between a lowermost metal layer 91, a dielectric layer 92 arranged on the metal layer 91 and an electrically conductive layer 93 that is arranged on the dielectric layer 92 and that forms the upper plate of the capacitor structure. The lowermost metal layer 91 may be formed from the same layer of the metallization structure 70 as the source and drain contacts, e.g. the electrically insulating layer 77 described with reference to figure 4C. The dielectric layer 92 may comprise a nitride, for example CP nitride. The upper plate 93 may be formed from a portion of the second electrically conductive layer 73 of the metallization structure 70. In auxiliary pad 16, an electrically insulating layer 94 is arranged on top of the second electrically conductive layer 93 and an electrically conductive layer 95 is located on the insulating layer 94. The electrically conductive layer 95 provides the contact surface of the auxiliary contact pad 16 and also extends to and is connected with the lower most electrically conductive layer 91. Thus, the lower plate 91 of the capacitor structure 90 is electrically connected to the outermost contact surface of the auxiliary contact pad 16. Therefore, in this embodiment, the auxiliary pad 16 provides a contact to the lower plate 91 of the capacitor structure 90.

Under the auxiliary pad 16' located in the corner of the component position 12', a stack of the electrically conductive layer 91, the dielectric layer 92 and the second electrically conductive layer 93 is provided. The auxiliary pad 16' is in direct contact with the second electrically conductive layer 93 and, therefore, forms a contact to the upper plate of the capacitor structure 90. In this embodiment, the first electrically conductive layer 91 extends from under the auxiliary pad 16' of the component position 12' to under the auxiliary pad 16 in the component position 12 The second electrically conductive layer 93 and the dielectric layer 92 also extends from under the auxiliary pad 16 to under the auxiliary pad 16'.

The capacitance across the dielectric layer 92 may be measured by placing the probe on the auxiliary pad 16 on the first component position 12 which is connected to the lower plate 91 and to the auxiliary pad 16' on the neighbouring second component position 12' which is connected to the upper plate 93 of the capacitor structure 90.

The auxiliary pads 16" and 16‴ located on component positions 12", 12''', respectively, may have the same structure as the auxiliary pad 16'. The first electrically conductive layer 91, dielectric layer 92 and the second dielectric layer 93 located under the auxiliary pad 16 ", 16‴ may extend between the auxiliary pads 16 ", 16"'and between the auxiliary pad 16" and auxiliary pad 16 and between the auxiliary 16‴ and the auxiliary pad 16'.

The capacitance across the dielectric layer 92 may be measured by placing the probe on the auxiliary pad 16 on the first component position 12 which is connected to the lower plate 91 and to the auxiliary pad 16" or auxiliary pad 16‴ on the neighbouring second component position 12" or 12‴ which is connected to the upper plate 93 of the capacitor structure 90.

In alternative embodiments, one of the further auxiliary pads, for example auxiliary pad 16 ", may have the structure of the auxiliary pad 16 and provide an electrical connection to the lower capacitor plate.

Figure 7 illustrates a flowchart 100 of a method for fabricating a semiconductor wafer.

In block 101, a semiconductor wafer is provided. The semiconductor wafer comprises a plurality of component positions arranged in rows and columns and the component positions are spaced apart from one another by a kerf region. In block 102, active device structures are formed in component positions. In block 103, one or more auxiliary structures are formed in one or more of the kerf regions. In block 104, a metallisation structure is formed on the component positions and on the kerf regions. In block 105, one or more auxiliary pads are formed in the metallization layer in one or more of the component positions, the one or more auxiliary pads being electrically coupled to one or more of the auxiliary structures that are arranged in the kerf regions. The auxiliary pad is electrically sperate from the active device located in that component position.

The semiconductor wafer may comprise a single crystal silicon wafer which may comprise an epitaxially deposited silicon layer, commonly known as an epi layer, which provides the drift region. Alternatively, the semiconductor wafer may comprise a III-V semiconductor, e.g. a Group III nitride. For example, a base wafer such as sapphire or silicon and an epitaxially grown Group III nitride multilayer structure on the base wafer.

The active device may be a transistor device, such as a HEMT or a MOSFET or a IGBT or a BJT device.

The auxiliary structure may be a transistor device, such as a HEMT or a MOSFET or a IGBT or a BJT device, a resistor or a capacitor.

After fabrication of the wafer, the method may further comprise applying an external contact to the auxiliary contact pad(s) and measuring one or more parameters of the auxiliary structure.

In some embodiments, the method may further comprise singulating the wafer by cutting along the kerf regions and through the auxiliary structure to form a plurality of semiconductor chips from the semiconductor wafer. Each of the chips comprises at least one auxiliary contact pad that is not electrically connected to the active device of the chip.

To summarize, an auxiliary structure is formed in the kerf region during the processing of a semiconductor wafer which does not interact with or affect the active device structures in the component positions of the processed semiconductor wafer. The auxiliary structure may be used to evaluate the manufacturing process of a semiconductor device such as the active device structures in the component positions. Examples of auxiliary structures include, for example, process control monitor (PCM) devices, for example electric PCM devices, lithographic structures, metal pads, contacts for electrochemical etching, and alignment structures. The wafer may also include auxiliary structures of different types for different purposes.

The auxiliary contact pad, that is connected to the auxiliary structure in the kerf region, is arranged on the component position rather than in the kerf region. This location of the auxiliary contact pad may assist in reducing defects or defective chips, such as reducing undesirable chipping of the top side, side walls and/or rear surface of the semiconductor material during separation of the semiconductor chips from the semiconductor wafer by the cutting action along the kerf regions and through the auxiliary contact pad and/or through the auxiliary structure. The location of the auxiliary contact pad on the component position rather than in the kerf region may assist in increasing the yield.

Although the present disclosure is not so limited, the following numbered examples demonstrate one or more aspects of the disclosure.

### Examples

1. A method of fabricating a semiconductor chip, comprising:
   providing a semiconductor wafer;
   forming active device structures in component positions with kerf regions located at least one of adjacent to and between the component positions;
   forming one or more auxiliary structures at least partially in one or more of the kerf regions;
   forming a metallization structure on the component positions and on the kerf regions;
   forming one or more auxiliary contact pads in the component positions that are electrically coupled to one or more of the auxiliary structures in the kerf regions;
   singulating the wafer by cutting along the kerf regions.
2. The method according to example 1, wherein the singulating the wafer further comprises cutting through the auxiliary structure.
3. A method according to example 11 or example 2, wherein the metallization structure comprises a redistribution structure for the active device structures in the component positions and at least one interconnect that extends from the auxiliary contact pad to the auxiliary structure in the kerf region, wherein the auxiliary contact pad and the interconnect are electrically separate from the active device structures.
4. A method according to any one of examples 1 to 3, wherein the forming a metallization structure comprises:
   forming a first conductive layer and
   structuring the first conductive layer to form a redistribution structure for the active device.
5. A method according to example 4, further comprising:
   structuring the first conductive layer to form at least one auxiliary contact pad that is electrically separate from the active device structures and/or an interconnect that extends from at least one of the auxiliary contact pads to at least one of the auxiliary structures.
6. A method according to example 4 or example 5, wherein the forming a metallization structure further comprises:
   forming a second conductive layer of the metallization structure, and
   structuring the second conductive layer to form a redistribution structure for the active device.
7. A method according to example60, further comprising structuring the second conductive layer to form at least one auxiliary contact pad that is electrically separate from the active device structures and/or an interconnect that extends from at least one of the auxiliary contact pads to at least one of the auxiliary structures.
8. A method according to any one of examples 1 to 7, wherein the component positions each comprise an edge region that laterally surrounds the active device structure and the auxiliary contact pad is located in the edge region.
9. A method according to any one of examples 1 to 8, wherein the kerf regions are arranged in a grid of vertical and horizontal kerf regions that intersect at intersections, wherein the auxiliary structure is formed in the intersection.
10. A method according to example 9, wherein one component position is bordered by two adjacent vertical kerf regions and two adjacent horizontal kerf regions and comprises four corners, wherein the metallization is structured to form one auxiliary contact pad that is located at the corner of the component position.
11. A method according to example 9 or example 10, wherein the metallization is structured to form one auxiliary contact pad on two or more of the component positions bordering the intersection.
12. A method according to any one of examples 9 to 11, wherein the metallization is structured to form the auxiliary contact pad that is located at the corner of two or more of the component positions bordering the intersection.
13. A method according to any one of examples 1 to 12, wherein the metallization is structured to form first and second auxiliary contact pads, the first and second auxiliary contact pads being located on a different one of the component positions and at least one interconnect that electrically connects the first and second auxiliary contact pads to at least one auxiliary structure.
14. A method according to any one of examples 1 to13, wherein further comprising forming a capacitor structure under the auxiliary contact pad by forming first conductive layer for a first plate of the capacitor, forming a dielectric layer on the first plate and forming the auxiliary contact pad on the dielectric layer to provide the second plate of the capacitor structure.
15. A method according to example 14, further comprising
   forming an insulation layer on the auxiliary contact pad,
   forming a contact pad on the insulation layer,
   forming a further interconnect that extends from the contact pad to the first conductive layer.
16. A method according to any one of examples 1 to 15, further comprising:
   structuring the metallization to form a metal interconnect forming a resistor, the metal interconnect providing the auxiliary structure that is located at least in part in the kerf region.
17. A method according to any one of examples 1 to 15, wherein the auxiliary structure is a transistor device and the metallization is structured to electrically couple the transistor device to three auxiliary contact pads, each located on a different one of the component positions bordering the intersection.
18. A method according to any one of examples 1 to 17, wherein the component positions each comprise and edge region that laterally surrounds the active device structures and one or more continuous rings are located in the edge region, wherein the metallization is structured such that the auxiliary contact pad is located on the one or more continuous rings or laterally between the kerf region and the one or more continuous rings.
19. A method according to any one of examples 1 to 18, wherein
   wherein the auxiliary contact pad has an area of at least 30 µm by 30 µm.
20. A method according to any one of examples 1 to 19, wherein
   wherein the active device structure is a HEMT or a MOSFET or a IGBT or a BJT device.
21. A method according to any one of examples 1 to 20, wherein the semiconductor wafer comprises monocrystalline or epitaxial silicon, or a III-V semiconductor, or a Group III nitride semiconductor, or a plurality of Group III nitride layers.
22. A method according to any one of examples 1 to 21, wherein at least one of forming the auxiliary structure and forming the active device structure comprises:
   forming a body region comprising a second conductivity type that opposes the first conductivity type in a semiconductor layer comprising a first conductivity type forming a drift region;
   forming a source region comprising the first conductivity type on the body region;
   forming an elongate trench in the first major surface,
   forming a gate electrode in the elongate trench.
23. A method according to example 22, further comprising forming a field plate in a lower portion of the elongate trench and forming the gate electrode above the field plate in the elongate trench.
23. A method according to any one of examples 1 to 21, wherein at least one of forming the auxiliary structure and forming the active device structure comprises:
   forming a drain finger, a source finger and a gate finger on the first major surface of the semiconductor wafer, the gate finger being arranged laterally between the source finger and the drain finger.
24. The method according to any one of examples 1 to 23, further comprising applying an external contact to the auxiliary contact pad and measuring one or more parameters of the auxiliary structure.
25. A semiconductor chip, comprising:
   a semiconductor substate comprising a first major surface and an active device,
   a metallization structure located on the first major surface and comprising an electrically conductive redistribution structure for the active device, at least one auxiliary contact pad and at least one interconnect that extends from the auxiliary contact pad,
   wherein the at least one auxiliary contact pad and the at least one interconnect are electrically separate from the active device.
26. The semiconductor chip according to example 25, wherein the chip comprises an edge region that laterally surrounds the active device structure and the auxiliary contact pad is located in the edge region.
27. A semiconductor chip according to example 25 or example 26, wherein the first major surface comprises four corners and one auxiliary contact pad is located at at least one of the corners.
28. The semiconductor chip according to any one of examples 25 to 27, wherein the auxiliary contact pad is part of a capacitor structure with a dielectric layer located between a first conductive layer and the auxiliary contact pad.
29. A semiconductor chip according to example 27 or example 28, wherein an insulation layer is located on the auxiliary contact pad and a contact pad is located on the insulation layer, wherein a further interconnect extends from the contact pad to the first conductive layer.
30. A semiconductor chip according to any one of examples 25 to 29, wherein the metallization structure comprises a first electrically conductive layer that is positioned on, and electrically coupled with, the active device structure in the component positions and the auxiliary contact pad is substantially coplanar with the first electrically conductive layer.
31. A semiconductor chip according any one of examples 25 to 30, wherein the metallization structure further comprises a second electrically conductive layer that is positioned on, and electrically coupled with, the active device structure and the at least one interconnect is coplanar with the second electrically conductive layer.
32. A semiconductor chip according to any one of examples 26 to 31, wherein the edge region comprises one or more continuous rings and the auxiliary contact pad is located on the one or more continuous rings or laterally between a side face of the chip and the one or more continuous rings.
33. A semiconductor chip according any one of examples 25 to 32, wherein the auxiliary contact pad has an area of at least 30 µm by 30 µm or at least 50 µm by 50 µm or at least 80 µm by 80 µm.
34. A semiconductor chip according to any one of examples 25 to 33, wherein the active device structure is a a HEMT or a MOSFET or a IGBT or a BJT device.
35. A semiconductor chip according to any one of examples 25 to 34, wherein the semiconductor material comprises monocrystalline or epitaxial silicon, or a III-V semiconductor, or a Group III nitride semiconductor, or a plurality of Group III nitride layers.
36. A semiconductor chip according to any one of examples 25 to 35, wherein the active device structure is a transistor device and the transistor device comprises a plurality of transistor cells, each active transistor cell comprising a drift region comprising a first conductivity type, a body region comprising a second conductivity type that opposes the first conductivity type on the drift region, a source region comprising the first conductivity type on and/or in the body region, a plurality of trenches, each trench comprising at least one of a field plate and a gate electrode.
37. The semiconductor chip of example 36, wherein the plurality trenches comprises a plurality of elongate trenches, each trench comprising a field plate and a gate electrode.
38. The semiconductor chip of example 36, wherein the plurality trenches comprises a plurality of columnar trenches, each columnar trench comprising a field plate, and a plurality of elongate trenches, each elongate trench comprising a gate electrode.
39. A semiconductor chip according to any one of examples 36 to 38, wherein the transistor device comprises a plurality of transistor cells coupled in parallel and each transistor cell comprises a drain finger, a source finger and a gate finger arranged on the first major surface, wherein the gate finger is arranged between the source finger and the drain finger.
40. A semiconductor chip according to example 39, wherein the semiconductor wafer comprises a support wafer, a buffer structure on the support wafer, a Group III nitride a channel layer on the buffer layer and a Group III nitride barrier layer on the Group III nitride channel layer which forms a heterojunction therebetween.
41. A semiconductor wafer, comprising:
   a plurality of component positions, each comprising an active device structure;
   kerf regions located at least one of adjacent to and between the component positions;
   at least one auxiliary structure at least partially positioned in one or more of the kerf regions, wherein the auxiliary structure is electrically coupled to at least one auxiliary contact pad that is located on one of the plurality of component positions.
42 A semiconductor wafer according to example 41, wherein the component positions each comprise an edge region that laterally surrounds the active device structure and the auxiliary contact pad is located in the edge region.
43. A semiconductor wafer according to example 41 or example 42, wherein the kerf regions are arranged in a grid of vertical and horizontal kerf regions that intersect at intersection regions, wherein the auxiliary structure is located in the intersection.
44. A semiconductor wafer according to any one of examples 41 to 43, wherein one component position is bordered by two adjacent vertical kerf regions and two adjacent horizontal kerf regions and comprises four corners, wherein one auxiliary contact pad is located at the corner of the component position.
45. A semiconductor wafer according to example 43 or example 44, wherein one auxiliary contact pad is located on two or more of the component positions bordering the intersection.
46. A semiconductor wafer according to any one of examples 41 to 45, wherein the auxiliary contact pad is located at the corner of two or more of the component positions bordering the intersection.
47. A semiconductor wafer according to any one of examples 41 to 46, wherein one auxiliary structure is electrically coupled to first and second auxiliary contact pads, the first and second auxiliary contact pads being located on different ones of the component positions.
48. A semiconductor wafer according to example 46 or 47, wherein the first auxiliary contact pad is part of a capacitor structure comprising a dielectric layer located between a first conductive layer and the first auxiliary contact pad.
49. A semiconductor wafer according to example 48, wherein an insulation layer is located on the auxiliary contact pad and a contact pad is located on the insulation layer, wherein a further interconnect extends from the contact pad to the first conductive layer.
50. A semiconductor wafer according to example 47, wherein the auxiliary structure is a metal interconnect forming a resistor.
51. A semiconductor wafer according to any one of examples 43 to 45, wherein the auxiliary structure is a transistor device and is electrically coupled to three auxiliary contact pads, each auxiliar contact pad being located on a different one of the component positions bordering the intersection.
52. A semiconductor wafer according to any one of examples 41 to 51, wherein the component positions each comprise a metallization structure comprising a redistribution structure for the active device and at least one interconnect that extends from the auxiliary contact pad to the auxiliary structure in the kerf region.
53. A semiconductor wafer according to example 52, wherein the metallization structure comprises a first electrically conductive layer that is positioned on, and electrically coupled with, the active device structure in the component positions and the auxiliary contact pad is substantially coplanar with the first electrically conductive layer.
54. A semiconductor wafer according to example 53, wherein the metallization structure further comprises a second electrically conductive layer that is positioned on, and electrically coupled with, the active device structure and the at least one interconnect is substantially coplanar with the second electrically conductive layer.
55. A semiconductor wafer according to any one of examples 41 to 54, wherein the auxiliary contact pad is electrically separate from the active device and/or the auxiliary structure in the kerf region is electrically separate from the active device.
56. A semiconductor wafer according to any one of examples 41 to 55, wherein the edge region of the component composition comprises one or more continuous rings, wherein the auxiliary contact pad is located on the one or more continuous rings or laterally between the kerf region and the one or more continuous rings.
57. A semiconductor wafer according to any one of examples 41 to 56, wherein the auxiliary contact pad has an area of at least 30 µm by 30 µm, or at least 50 µm by 50 µm, or at least 80 µm by 80 µm.
58. A semiconductor wafer according to any one of examples 41 to 57, wherein the active device structure is a transistor device formed in the semiconductor material of the component position and the transistor device is a HEMT or a MOSFET or a IGBT or a BJT device.
59. A semiconductor wafer according to any one of examples 41 to 58, wherein the semiconductor material comprises monocrystalline or epitaxial silicon, or a III-V semiconductor, or a Group III nitride semiconductor, or a plurality of Group III nitride layers.
60. A semiconductor wafer according to any one of examples 41 to 59, wherein the active device structure is a transistor device formed in the semiconductor material of the component position, wherein the transistor device comprises a plurality of active transistor cells, each active transistor cell comprising a drift region comprising a first conductivity type, a body region comprising a second conductivity type that opposes the first conductivity type on the drift region, a source region comprising the first conductivity type on and/or in the body region, a plurality of trenches, each trench comprising at least one of a field plate and a gate electrode.
61. A semiconductor wafer according to any one of examples 41 to 59, wherein the plurality trenches comprises a plurality of columnar trenches, each columnar trench comprising a field plate, and a plurality of elongate trenches, each elongate trench comprising a gate electrode.
62. A semiconductor wafer according to any one of examples 41 to 59, wherein the transistor device comprises a plurality of transistor cells coupled in parallel and each transistor cell comprises a drain finger, a source finger and a gate finger arranged on the first major surface, wherein the gate finger is arranged between the source finger and the drain finger.
63. A semiconductor wafer according to example 62, wherein the semiconductor wafer comprises a support wafer, a buffer structure on the support wafer, a Group III nitride a channel layer on the buffer layer and a Group III nitride barrier layer on the Group III nitride channel layer which forms a heterojunction therebetween.

Spatially relative terms such as "under", "below", "lower", "over", "upper" and the like are used for ease of description to explain the positioning of one element relative to a second element. These terms are intended to encompass different orientations of the device in addition to different orientations than those depicted in the figures. Further, terms such as "first", "second", and the like, are also used to describe various elements, regions, sections, etc. and are also not intended to be limiting. Like terms refer to like elements throughout the description.

As used herein, the terms "having", "containing", "including", "comprising" and the like are open ended terms that indicate the presence of stated elements or features, but do not preclude additional elements or features. The articles "a", "an" and "the" are intended to include the plural as well as the singular, unless the context clearly indicates otherwise. It is to be understood that the features of the various embodiments described herein may be combined with each other, unless specifically noted otherwise.

Although specific embodiments have been illustrated and described herein, it will be appreciated by those of ordinary skill in the art that a variety of alternate and/or equivalent implementations may be substituted for the specific embodiments shown and described without departing from the scope of the present invention. This application is intended to cover any adaptations or variations of the specific embodiments discussed herein. Therefore, it is intended that this invention be limited only by the claims and the equivalents thereof.

## Claims

1. A method of fabricating a semiconductor chip, comprising:
providing a semiconductor wafer (10) comprising component positions (12) with kerf regions (13) located at least one of adjacent to and between the component positions (12);
forming active device structures (14) in the component positions (12);
forming one or more auxiliary structures (15) at least partially in one or more of the kerf regions (13);
forming a metallization structure (17) on the component positions (12) and on the kerf regions (13);
forming one or more auxiliary contact pads (16) in the component positions (12) that are electrically coupled to one or more of the auxiliary structures (15) in the kerf regions (13);
singulating the wafer (10) by cutting along the kerf regions (13).

2. A method according to claim 1, wherein the metallization structure (17) comprises a redistribution structure for the active device structures (14) and the auxiliary pad (16) in the component positions (12) and at least one interconnect (26) that extends from the auxiliary contact pad (16) to the auxiliary structure (15) in the kerf region (13) , wherein the auxiliary contact pad (16) and the interconnect (26) are electrically separate from the active device structures (14).

3. A method according to claim 1 or claim 2, wherein the forming a metallization structure (17) comprises:
forming a first conductive layer (72) and
structuring the first conductive layer (72) to form a redistribution structure for the active device (14).

4. A method according to claim 3, further comprising:
structuring the first conductive layer (72) to form at least one auxiliary contact pad (16) that is electrically separate from the active device structures (15) and/or an interconnect (26) that extends from at least one of the auxiliary contact pads (16) to at least one of the auxiliary structures (15).

5. A method according to any one of claims 2 to 4, wherein the forming a metallization structure (17) further comprises:
forming a second conductive layer (75) of the metallization structure (17), and
structuring the second conductive layer (75) to form the redistribution structure for the active device (14).

6. A method according to claim 5, further comprising structuring the second conductive layer (75) to form at least one auxiliary contact pad (15) that is electrically separate from the active device structures (14) and/or an interconnect (26) that extends from at least one of the auxiliary contact pads (16) to at least one of the auxiliary structures (15).

7. A method according to any one of claims 1 to 6, wherein the kerf regions (13, 13') are arranged in a grid of vertical and horizontal kerf regions that intersect at intersections (25), wherein the auxiliary structure (15) is formed in the intersection (25).

8. A method according to claim 7, wherein one component position (12) is bordered by two adjacent longitudinal kerf regions (13) and two adjacent transverse kerf regions (13') and comprises four corners (84), wherein the metallization (17) is structured to form one auxiliary contact pad (16) that is located at the corner (84) of the component position (12).

9. A method according to claim 7 or claim 8, wherein the metallization (17) is structured to form one auxiliary contact pad (16) located at the corner (84) of two or more of the component positions (16, 16') bordering the intersection (25).

10. A method according to any one of claims 1 to 9, wherein the metallization (17) is structured to form first and second auxiliary contact pads (16, 16'), the first and second auxiliary contact pads (16, 16') being located on a different one of the component positions (12, 12') and at least one interconnect (83) that electrically connects the first and second auxiliary contact pads (16, 16') to at least one auxiliary structure (15).

11. A method according to any one of claims 1 to 10, wherein further comprising forming a capacitor structure (90) under the auxiliary contact pad (16) by forming first conductive layer for a first plate (91) of the capacitor structure (90), forming a dielectric layer (92) on the first plate (90) and forming the auxiliary contact pad (16) on the dielectric layer (92) to provide the second plate (93) of the capacitor structure (90).

12. A semiconductor chip (20), comprising:
a semiconductor substate (10) comprising a first major surface (11) and an active device (14),
a metallization structure (17) located on the first major surface (11) and comprising an electrically conductive redistribution structure for the active device (14), at least one auxiliary contact pad (16) and at least one interconnect (26) that extends from the auxiliary contact pad (16),
wherein the at least one auxiliary contact pad (16) and the at least one interconnect (26) are electrically separate from the active device (14).

13. A semiconductor chip according to claim 12, wherein the first major surface (11) comprises four corners (84) and one auxiliary contact pad (16) is located at at least one of the corners (84).

14. A semiconductor chip according to claim 12 or claim 13, wherein the metallization structure (17) comprises a first electrically conductive layer (72) that is positioned on, and electrically coupled with, the active device structure (14) and the auxiliary contact pad (16) is substantially coplanar with the first electrically conductive layer (72).

15. A semiconductor wafer (10), comprising:
a plurality of component positions (12), each comprising an active device structure (14);
kerf regions (13, 13') located at least one of adjacent to and between the component positions (12);
at least one auxiliary structure (15) at least partially positioned in one or more of the kerf regions (13, 13'), wherein the auxiliary structure (15) is electrically coupled to at least one auxiliary contact pad (16) that is located on one of the plurality of component positions (12).
